# EUROPEAN PATENT APPLICATION

(11) **EP 0 797 240 A2**
(43) Date of publication of application: **24.09.1997**
(21) Application number: 97103323.8
(22) Date of filing: 28.02.1997
(51) Int. Cl.: H01L 21/00

(54) **Reduced footprint semiconductor processing system**

(30) Priority: 04.03.1996 US 610708
(71) Applicant: Applied Materials, Inc., Santa Clara, CA 95054 (US)
(72) Inventor: Nulman, Jaim, Palo Alto, CA 94306 (US); Bachrach, Robert Z., Palo Alto, CA 94306 (US)
(74) Representative: Kahler, Kurt, Dipl.-Ing.

(57) **Abstract**

The invention relates to a wafer processing system (10) having processing chambers on at least two levels (16, 22) wherein the levels are vertically displaced relative to each other. Preferably, at least one chamber on the second level (22) is located above a chamber on the lower level (16) in a substantially overlapping relationship. An elevator chamber (24, 26) is provided to transport work pieces between the two processing levels. In this manner, the floorspace footprint of the processing system (10) can be reduced.

## Description

### BACKGROUND OF THE INVENTION

The present invention relates generally to semiconductor processing systems, and more particularly to robotic semiconductor processing systems.

In order to decrease contamination and to enhance through-put, semiconductor processing systems often utilize one or more robots to transfer semiconductor wafers and other workpieces between a number of different vacuum chambers which perform a variety of tasks. An article entitled "Dry Etching Systems: Gearing Up for Larger Wafers", in the October, 1985 issue of Semiconductor International magazine, pages 48-60, describes a four-chamber dry etching system in which a robot in a pentagonal-shaped housing serves four plasma etching chambers and a cassette load/unload load lock chamber mounted on the robot housing. Although the increased vacuum isolation provided by such systems can improve product quality, it has been difficult to achieve commercially acceptable throughput for high vacuum processes, such as, for example, physical vapor processes such as sputtering. Before the robot can unload the unprocessed wafers from the cassette, the load lock chamber must be pumped down to the required vacuum level. The time required to pump down processing chambers or the load lock chambers to the base level, following loading of a cassette of wafers into the load lock chamber, can be excessive.

It has been found that throughput can be significantly improved while maintaining vacuum isolation by adding intermediate and buffer chambers at varying levels of pressure between high vacuum process chambers and relatively lower vacuum pressure load lock chambers. For example, U.S. Pat. No. 5,186,718, which is incorporated herein by reference, describes a semiconductor processing system having in addition to a robot transfer chamber, a robot buffer chamber and a pair of intermediate processing or treatment chambers. In this system, load lock chambers and pretreating and orienter chambers are positioned around the robot buffer chamber whereas high vacuum processing chambers are arrayed around the robot transfer chamber. Wafers being transferred from the robot buffer chamber to the robot transfer chamber pass through the intermediate treatment chambers.

In the system of U.S. Patent No. 5,186,718, the robot buffer chamber, robot transfer chamber and the intermediate treatment chambers, together with interconnecting corridors are formed by machining a monolithic piece of material, typically aluminum. The use of the monolithic construction facilitates alignment of the individual chambers for wafer transport and also reduces or eliminates difficulties in sealing the individual chambers of the monolith.

A staged vacuum is applied across the system with the degree of vacuum increasing in order from the cassette load lock chambers to the high vacuum processing chambers. Consequently, the time required to pump down the robot buffer chamber to its base vacuum level subsequent to the loading of a cassette is minimized. In addition, very high degrees of vacuum can be used in the high vacuum processing chambers without lengthy pump down times.

Such a arrangement has been found to provide an excellent automated wafer processing system with a very high throughput and product quality. However, because of the relatively large number of chambers, it has been noted by the present inventors that the system as a whole can occupy a substantial amount of floor space. This can be a particular problem in locations where land is very scarce. In addition, because wafer processing is preferably performed in clean room conditions, providing a sufficiently large clean room can further substantially increase costs. This is exacerbated when the wafer diameter increases below the current 200 mm diameter commonly used in semiconductor manufacturing.

### SUMMARY OF THE INVENTION

It is an object of the present invention to provide an improved wafer processing system, obviating, for practical purposes, the above mentioned limitations.

These and other objects and advantages are achieved by the features described in claims 1 and 16, respectively.

In particular, the present invention provides a wafer processing system having processing chambers on at least two levels wherein the levels are vertically displaced relative to each other. An elevator is provided to transport work pieces between the two processing levels. In this manner, the footprint of the processing system can be reduced while maintaining the very high throughput and product quality that has been achieved in prior single level systems.

### BRIEF DESCRIPTION OF THE DRAWINGS

Fig. 1 is an elevational view of a semiconductor processing system in accordance with one embodiment of the present invention.

Fig. 2A is a cross-sectional view of the processing system of Fig. 1 viewed along the lines 2A-2A of Fig. 1.

Fig. 2B is a cross-sectional view of the processing system of Fig. 1 viewed along the lines 2B-2B of Fig. 1.

Fig. 3 is a cross-sectional view of one of the elevators of the processing system of Fig. 2B viewed along the lines 3-3 of Fig. 2B.

### DETAILED DESCRIPTION OF THE INVENTION

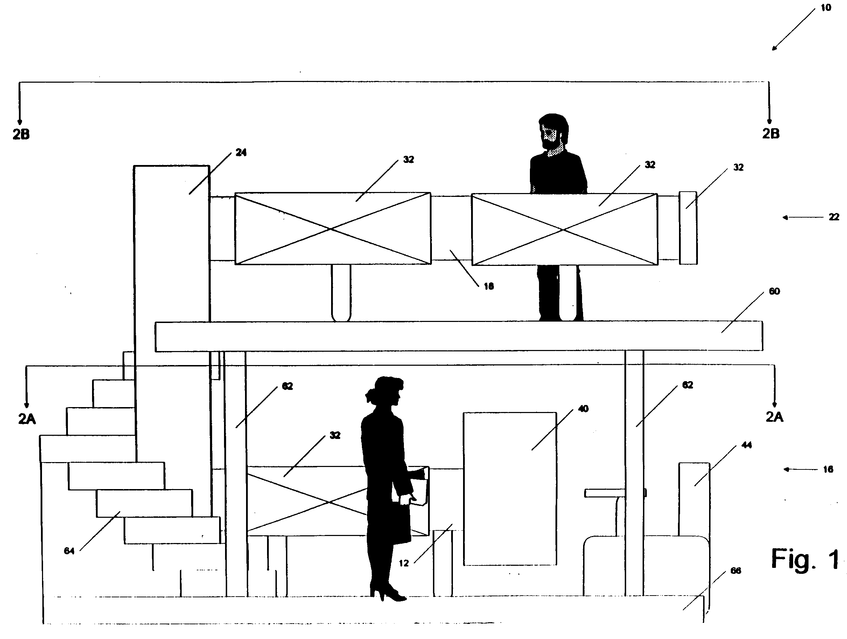

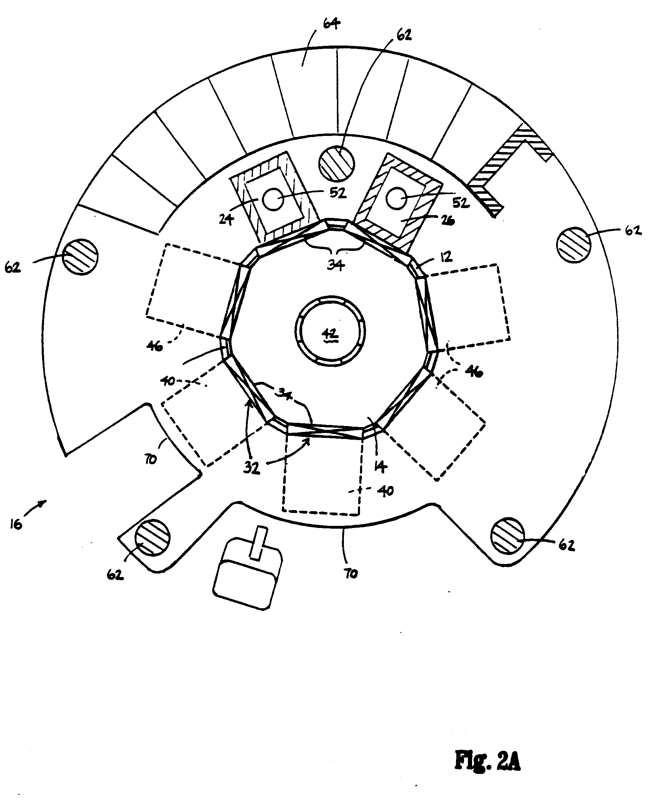

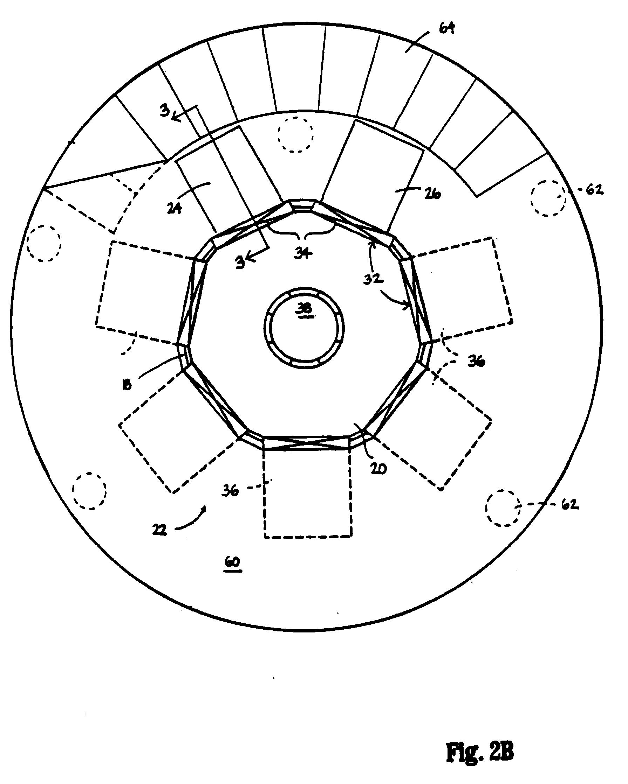

A wafer processing system in accordance with a preferred embodiment of the present invention is indicated generally at 10 in Fig. 1. The system 10 includes a lower housing 12 which defines a robot buffer chamber 14 (Fig. 2A) at a first level 16. An upper housing 18 defines a transfer robot chamber 20 (Fig. 2B) at a second, upper level 22 positioned over the lower housing 12. One, two or more elevator chambers such as the elevator chambers 24 and 26 (Figs. 2A, 2B) couple the robot buffer chamber 14 at the lower level 16 to the robot transfer chamber 20 at the upper level 22. As will be explained in greater detail below, the use of one or more elevator chambers permits the 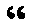 footprint 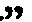 , that is the total floor space occupied by the system 10, to be substantially reduced.

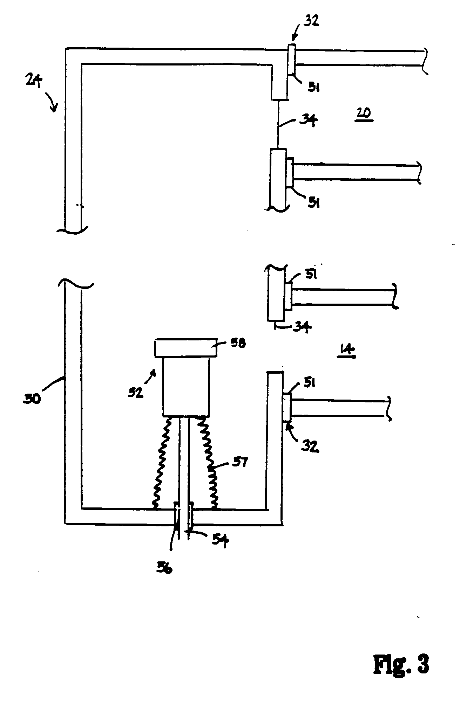

As best seen in Figs. 2A, 2B and 3, the robot buffer chamber 14 and the robot transfer chamber 30 each have a plurality (as used herein, "plurality" means two or more) of access ports 32 to which various other chambers including the elevator chambers 24 and 26 are coupled. Each access port 32 has a slit valve 34 which may be opened to permit a wafer or other workpiece to pass from one chamber through the access port to the adjoining chamber, or may be closed to close the access port in a pressure tight seal. Suitable slit valves are described in issued U.S. Patent No. 4,785,962, which is incorporated herein by reference.

On the upper level 22 (Fig. 2B), coupled to access ports 32 about the periphery of the robot transfer chamber 20, is a plurality of high vacuum processing chambers 36. The chambers 36 may be adapted for various types of processing including etching and deposition. Although five such upper level processing chambers 36 have been illustrated, it is recognized of course that the transfer chamber 20 may be adapted to have a greater or fewer number of access ports to accommodate a greater or fewer number of processing chambers 36, depending upon the particular application. A robot 38 transfers wafers between the various processing chambers 36.

Referring now to the lower level 16 (Fig. 2A), coupled to access ports 32 on the opposite side of the robot buffer chamber 14 as the elevator chambers 24 and 26, is a plurality of load lock chambers 40 which include removable cassettes of wafers to be processed or wafers already processed. A robot 42 in the center of the robot buffer chamber 14 unloads unprocessed wafers from a cassette in one of the load lock chambers 40 and transfers the wafers for processing. Once processing is complete, the robot 42 places each processed wafer into an empty slot in one of the cassettes of the load lock chambers 40. When a cassette has been filled with processed wafers, the slit valve of the access port 32 for that load lock is closed and a robot 44 (Fig. 1) removes the cassette and replaces it with a cassette filled with unprocessed wafers. Alternative to robot handling, cassettes may be loaded and unloaded by hand.

The robot buffer chamber 14 also has a plurality of processing chambers 46 coupled to the remaining access ports 32. Although two such lower level processing chambers are illustrated, it is anticipated that the buffer chamber 14 may be adapted to accommodate a greater or smaller number of processing chambers 46, depending upon the particular application. These chambers 46 may be used for a variety of functions. For example, one chamber 46 may be an orienter which is used to orient the wafer flats or notch of the wafer prior to further processing. Another chamber 46 may also be dedicated to other pre-processing treatments such as etch cleaning or heating a wafer or both. Alternatively, one or more of the chambers 46 may be used for post-processing treatments (such as cooling), for both pre-processing and post-processing treatments, or for processing itself.

The lower level processing chambers 46 are effectively isolated from the upper level processing chambers 36 by the intervening individually isolated buffer chamber 14, elevator chambers 24 and 26 and transfer chamber 20 (Fig. 2B). Thus, lower level chambers 46 can be conveniently used for processes which require a different (even incompatible) chemistry and a different (typically lower) pressure relative to the group of upper level processing chambers 36. For example, the high degree of isolation facilitates the use of corrosive gas chemistry in the chambers 36 without affecting the atmosphere and processing or treatment in the chambers 46.

In the illustrated embodiment, the upper robot chamber 20 and the lower robot chamber 14 are substantially centered with respect to each other in an overlapping relationship to minimize the footprint of the system. Of course, other non-overlapping arrangements of the chambers are also possible.

The robot chambers 14 and 20 communicate with one another via the elevator chambers 24 and 26. In one feature of the present invention, one elevator chamber such as chamber 24 can be dedicated to lifting wafers from the lower level robot buffer chamber 14 up to the upper robot transfer chamber 20. Similarly, the other elevator chamber such as chamber 26 can be dedicated to lowering wafers from the upper robot transfer chamber 20 down to the lower buffer chamber 14. As shown in Fig. 3, a representative elevator chamber includes a pressure-tight housing 50 which sealingly couples to the access ports 32 of both the lower level buffer chamber 14 and the upper level transfer chamber 20. The access ports 32 have interlocking seals 51 which permit the elevator chambers to be repeatedly removed from the chambers 14 and 20 for cleaning and servicing and then reattached. The interlocking seals 51 are similar in construction to conventional seals for the chambers 36 and 46 which are also preferably removable for servicing and cleaning. Alternatively, interior seals 51 may differ from those for the processing chambers to allow moving the elevators relative to the monolithic structure for alignment purposes and to ensure vacuum integrity.

In the illustrated embodiment, a slit valve 34a when open couples the robot chamber 14 to the elevator chamber and a second slit valve 34b when open couples the robot chamber 20 to the elevator chamber. In order to preserve pressure differentials between the robot chambers 14 and 20, it is preferred that only one of the slit valves 34a, 34b be open at any one time. Fig. 3 illustrates the slit valve 34a in the open position and the slit valve 34b in the closed position.

An electrostatic chuck 52 could be adapted to firmly chuck or clamp a wafer placed on the chuck 52 by the robot 42 of the lower level buffer chamber 14 or the robot 38 of the upper transfer chamber 20, to hold the wafer in place as the wafer is elevated between the two levels. The electrostatic chuck may be controlled to release the wafer to be picked up by one of the robots 38 or 42 at the destination level. Although an electrostatic chuck has been described for holding the wafer, it is recognized that any of a variety of known devices for securing a wafer during transport may be used including robot blades, plates and pockets.

The chuck 52 holding the wafer may be raised to the upper level and lowered to the lower level by any of a variety of suitable pneumatic and electro-mechanical mechanisms including a moveable shaft 54 as illustrated. The elevator housing 50 may include suitable pressure seals 56 which permit the shaft 54 to slide through the bottom of the elevator housing 50 while maintaining pressure. The shaft 50 may be sealed with a bellows type arrangement as indicated at 57. Other suitable mechanisms for elevating the wafers include mechanisms exterior to the housing 50 which are magnetically coupled to the wafer holder.

In the illustrated embodiment, the chuck 52 has a heating plate 58 for heating the wafer prior to processing on the upper level. Alternatively, the chuck 52 may have a cooling plate to cool the wafer after processing on the upper level. Other types of treatments to the wafers may also be performed by the elevator chambers 24 and 26. Thus, besides performing the function of elevating the wafers between the upper and lower levels, the elevator chambers 24 and 26 may be used as pre-treating and post-treating chambers. These treating functions may be performed while the wafer is in transit between levels or while the chuck 52 is stationary. Thus, one of the elevator chambers may be used as a pre-treating chamber while the other elevator chamber is used for pretreatment while wafers move between levels. These functions, elevating and treating may be switched back and forth between the two elevator-treatment chambers 24 and 26 as needed during the processing cycles. In some applications, it may be appropriate to provide no treatment as the wafers are transported between levels.

In the illustrated embodiment, two such elevator-treatment chambers are depicted. It is recognized however, that fewer or greater numbers of elevator chambers may be utilized depending upon the particular application.

Preferably, the housing 12 of the lower level 16 is a monolith, i.e., it is machined or otherwise fabricated of one piece of material such as aluminum to form the buffer chamber 14. Similarly, the housing 18 of the upper transfer chamber 20 and the housings 50 of the elevator chamber 24 and 26 may be formed as monoliths also. These may be separate monolithic structures joined together or alternatively, the lower level housing 12, the upper housing 18 and the elevator housings 50 may all be formed as a single monolithic structure machined from a single piece of aluminum or other suitable material. In yet another embodiment, the elevator housings 50 may be formed as a monolithic structure with just one of the upper and lower housings 12 and 18. The use of a monolithic construction facilitates alignment of the individual chambers for wafer transport and also reduces or eliminates difficulties in sealing the individual chambers. Alternatively, the housings may be assemblies of component parts joined in pressure tight joints.

As best seen in Fig. 1, the upper level 22 is supported by a platform 60 positioned directly above the lower level 16. The platform 60 is supported by a plurality of upstanding posts 62 which are preferably tall enough to provide sufficient headroom beneath the platform 60 for workers attending the lower level 16 of the system. As best seen in Fig. 2B, the platform 60 preferably is sufficiently wide and long to provide access to each of the processing chambers 36 of the upper level 22 as well as the elevator chambers 24 and 26 for servicing and cleaning by workers on the upper level 22. A stairway 64 between the upper level 22 and the lower level 16 allows workers to readily move between the upper and lower levels as needed. Although not shown for purposes of clarity, suitable guardrails should be positioned around the perimeter of the upper platform 60 as well as the stairway 64 to prevent accidental falls. Although the upper and lower levels are shown as being relatively widely spaced, the upper and lower levels may alternatively be positioned much closer together and even touching with no intervening space between the upper and lower levels.

The lower level 16 may also be placed on a platform 66 as shown. Such an arrangement permits the platforms 60 and 66, the supporting posts 62 and the stairway 64 to be assembled to form a single structural unit which does not require structural modifications to the underlying floor. Although not shown, the supporting posts 62 may be cross-braced as needed, particularly in earthquake prone locations. To facilitate access by the cassette handling robot 44 to the load lock chambers 40 on the lower level, the platform 66 may be cut back as indicated at 70 in Fig. 2A to provide a path at floor level for the robot 44 to the load lock chambers. Alternatively, ramps may be provided between the floor level and the platform 66. Although the platforms are illustrated as being generally round in shape, it is anticipated that the platforms may have any of a variety of shapes including square, rectangular, hexagonal, etc. to permit adjacent wafer processing systems to be positioned as closely as appropriate to minimize space between systems.

One typical operational cycle of wafer transport through the system 10 is as follows. Initially, buffer robot 42 in chamber 14 picks up an unprocessed wafer from a cassette load lock chamber 40 and transports the wafer to a lower level processing chamber 46 which may orient the wafer, for example. The robot 42 may then transfer the wafer to another lower level processing chamber 46 to etch clean the surface of the wafer or heat the wafer. Upon the completion of lower level processing, the transfer robot 42 in chamber 14 picks up the wafer from the appropriate lower level processing chamber 46 and transfers the wafer to one of the elevator-treatment chambers 24 or 26 to be transported directly to the upper level for further processing. Alternatively, the wafer could be transferred to an elevator-treatment chamber for further pretreating such as heating before being transferred to the upper level or even while being transferred to the upper level.

Once the wafer arrives at the upper level, the chuck 52 releases the wafer permitting the transfer robot 38 to pick up the wafer and transfer it to a selected one of the preferably high vacuum processing chambers 36. Following processing in that chamber, transfer robot 38 can transfer the wafer selectively to one or more of the other chambers 36 for processing. Upon completion of upper level processing, the transfer robot 42 transfers the wafer to one of the elevator-treatment chambers 24, 26 to be transported directly down to the robot 42 of the lower level. Alternatively, the elevator-treatment chamber can post-process treat the wafer such as cooling it before or while transferring it down to the lower level robot 42.

After the wafer arrives at the lower level and after any cool-down cycle of the elevator-treatment chamber 24, 26, the lower level buffer robot 42 retrieves the wafer from the elevator-treatment chamber and returns it to the appropriate cassette load lock chamber 40. Alternatively, the robot 42 can transfer the wafer to one of the lower level processing chambers 46 for further post-processing treatments.

Because the upper level 22 is positioned over the lower level 16, the footprint of the system 10 is substantially reduced notwithstanding the large number of chambers which provide isolation to improve throughput and product quality. More specifically, in the system 10 of the illustrated embodiment, each chamber stage (main processing chambers 34/transfer robot chamber 24/intermediate processing chambers 26, 27/buffer robot chamber 24/load lock chambers 40) can be isolated from all the other chambers. Preferably, none of the chambers or stages, with the exception of the cassette load lock(s) 40, is vented to atmosphere during processing. In addition, during wafer transfer, preferably, only one slit valve is open in any transfer chamber at one time. As a result, variations in vacuum level and, specifically, reductions in the vacuum level during wafer transfer can be minimized by using a vacuum pumping system (not shown), to provide a vacuum gradient across the system from the cassette load lock 40 to the vacuum processing chambers 34. The staged vacuum is applied across the system by a suitable pump system (not shown) with the degree of vacuum increasing in order from the cassette load locks 40 to the processing chambers 34. Consequently, the time required to pump down load lock chamber 40 to its base vacuum level subsequent to the loading of a wafer therein is minimized and very high degrees of vacuum can be used in the upper level processing chambers 36 without lengthy pump down times and, thus, without adversely affecting system throughput. Also, since the wafers can be pre-cleaned and pre-heated before entering high vacuum, there is less system contamination and throughput is increased. Consequently, product quality and throughput are maintained while the footprint is substantially reduced by overlaying upper and lower processing levels.

In a presently preferred embodiment, buffer robot 42 is a dual four-bar link robot as disclosed in issued U.S. Patent No. 4,785,962 which is incorporated by reference. This robot is preferred for the use in the buffer chamber 14 in part because it combines a folded, very compact configuration and footprint with a relatively long reach and, thus, the capability to service the cassette load locks 40, the lower level processing chambers 46 and the elevator-treatment chambers 24, 26.

The presently preferred transfer robot 38 is described in issued U.S. Pat. No. 5,186,718, which is incorporated herein by reference. As discussed therein it is preferred that the robot have a long reach, a minimum of gears and other moving parts, and effective sealing for high vacuum environments used in processes such as physical vapor deposition. The robot should be capable of both rotation and translational motion. It is recognized that a variety of robots may be utilized.

Having thus described preferred and alternative embodiments of our present invention, it is understood that one of usual skill in the art will derive alternatives and variations which are within the scope of the invention.

## Claims

1. A system for processing semiconductor workpieces, comprising:
a first robot transfer chamber on a first level;
a second robot transfer chamber on a second level vertically displaced relative to the first level; and
an elevator chamber coupled between the first and second levels for vertically transporting workpieces between the first and second levels.

2. The system of claim 1 further comprising first and second monolithic structures which include the first and second robot transfer chambers, respectively.

3. The system of claim 1 further comprising a monolithic structure which includes the first and second robot transfer chambers and the elevator chamber.

4. The system of claim 1 further comprising a monolithic structure which includes the elevator chamber and one of the first and second robot transfer chambers.

5. The system of claim 1 wherein the second robot transfer chamber is located above and overlapping the first robot transfer chamber.

6. The system of claim 1 further comprising a plurality of processing chambers coupled to first robot transfer chamber.

7. The system of claim 6 further comprising a first robot positioned within the first robot transfer chamber for transporting workpieces between a first plurality of processing chambers and the elevator chamber.

8. The system of claim 7 wherein the first robot transfer chamber and the elevator chamber each comprise a pressure-tight housing which housings have a first valve coupling the first robot transfer chamber housing to the elevator chamber housing, said first valve having an open position to permit a workpiece to be transferred between a first processing chamber and the elevator chamber, and a closed position to pressure seal at least one of the first robot transfer chamber housing and the elevator chamber housing.

9. The system of claim 8 further comprising a second plurality of processing chambers coupled to the second robot transfer chamber.

10. The system of claim 9 further comprising a second robot positioned within the second robot chamber for transporting workpieces between a second processing chamber and the elevator chamber.

11. The system of claim 10 wherein the second robot chamber and the elevator chamber each comprise a pressure-tight housing which housings have a second valve coupling the second robot chamber housing to the elevator chamber housing, said second valve having an open position to permit a workpiece to be transferred between a second processing chamber and the elevator chamber, and a closed position to pressure seal at least one of the second robot transfer chamber housing and the elevator chamber housing.

12. The system of claim 1 wherein the elevator chamber comprises a chuck for holding the workpiece as it is transported between levels.

13. The system of claim 1 wherein the elevator chamber comprises a heating plate for heating the workpiece.

14. The system of claim 1 wherein the elevator chamber comprises a cooling plate for cooling the workpiece.

15. The system of claim 1 further comprising a second elevator chamber coupled between the first and second levels for vertically transporting workpieces between the first and second levels.

16. A method of processing semiconductor workpieces, comprising:
processing the workpiece in a first plurality of chambers on a first level;
elevating the workpiece in a elevator chamber between the first level and a second level vertically displaced relative to the first level; and
processing the workpiece in a second plurality of chambers on the second level.

17. The method of claim 16 further comprising:
lowering the workpiece in an elevator chamber between the first and second levels; and
placing the wafer in a cassette in a load lock chamber.

18. The method of claim 16 wherein the second plurality of processing chambers are located above the first plurality of processing chambers.

19. The method of claim 16 further comprising holding the workpiece while it is transported between the first and second levels.

20. The method of claim 19 wherein the workpiece is held by a chuck as it is transported between the first and second levels.

21. The method of claim 16 further comprising heating the workpiece while it is transported between the first and second levels.

22. The method of claim 16 further comprising cooling the workpiece while it is transported between the first and second levels.

23. The method of claim 16 further comprising transporting the workpiece from one of the first plurality of chambers to a buffer chamber upon completion of processing in said one of the first plurality of chambers and transporting the workpiece from the buffer chamber to the elevator chamber.

24. The method of claim 23 further comprising opening a valve between the buffer chamber and the elevator chamber to permit a workpiece to be transported between the buffer chamber and the elevator chamber through the valve.

25. The method of claim 24 further comprising:
transporting a workpiece from the elevator chamber to a transfer chamber when the workpiece reaches the second level; and
transporting the workpiece from the transfer chamber to one of the second plurality of chambers.

26. The method of claim 25 further comprising opening a second valve between the transfer chamber and the elevator chamber to permit a workpiece to be transported between the transfer chamber and the elevator chamber through the second valve.

27. The method of claim 25 further comprising transporting a workpiece from one of the second plurality of chambers, through the transfer chamber to the elevator chamber upon completion of processing in the second chamber.
